# EUROPEAN PATENT APPLICATION

(11) **EP 4 648 572 A1**
(43) Date of publication of application: **12.11.2025**
(21) Application number: 25172450.6
(22) Date of filing: 24.04.2025
(51) Int. Cl.: H05K 7/20

(54) **DATA CENTER CHILLING SYSTEM WITH WASTE HEAT RECYCLING**

(30) Priority: 10.05.2024 IN 202421037102; 02.04.2025 US 202519098664
(71) Applicant: Vertiv Corporation, Westerville, OH 43082 (US)
(72) Inventor: Bhangre, Piyush Balkrishna, Westerville, 43082 (US); Deshmukh, Abhijeet Vinod, Westerville, 43082 (US)
(74) Representative: Cousens, Nico

(57) **Abstract**

A system may include a cabinet comprising: at least one side panel, an air inlet, an air outlet; and an air movement unit disposed in the cabinet. The system may include at least one thermoelectric module coupled to at least one of the at least one side panels of the cabinet, the at least one thermoelectric module comprising: a first heat transfer surface located on or toward an interior of the cabinet; and a second heat transfer surface located on an exterior of the cabinet wherein the first heat transfer surface is configured to be heated by air moving through the air inlet via the air movement unit thereby creating a temperature gradient between the first heat transfer surface and the second heat transfer surface.

## Description

### CROSS-REFERENCE TO RELATED APPLICATIONS

The present application claims priority to Indian Provisional Patent Application Number 202421037102, filed May 10, 2024.

### FIELD OF INVENTION

The present invention relates to chilling units, and more particularly, this invention relates to chilling units with thermoelectric gradient modules that allow for waste heat to be captured and recycled.

### BACKGROUND

Chiller units are essential components in industries such as air conditioning, refrigeration, data centers, and manufacturing processes where precise temperature control is crucial. These units operate by removing heat from a specific environment and transferring it to a cooling medium, typically a refrigerant. Traditional chiller units exhaust this waste heat into the environment, leading to energy inefficiencies and environmental concerns.

Conventional chiller units often rely solely on electrical or mechanical cooling systems, which consume a significant amount of energy. The demand for improved energy efficiency and reduced greenhouse gas emissions has driven the development of more environmentally friendly and sustainable cooling solutions.

In data centers, hot air is collected and released outside the data center, or it is collected, cooled, and sent back to the data center again. The energy from the hot air is not utilized or harnessed for any other application or purpose. This results in a waste of heat energy in every cooling cycle, in addition to the extra energy needed to cool the hot air if it is going to be cooled and reused in the data center.

The conversion of heat energy to electrical power has been a topic of extensive research due to its potential for sustainable energy generation and waste heat utilization. The Seebeck effect, a thermoelectric phenomenon, forms the basis of many thermoelectric generators. This effect occurs when a temperature gradient is applied across a conductor, resulting in the generation of an electrical current flow. However, existing thermoelectric technologies face limitations in terms of efficiency, scalability, and adaptability to specific applications.

Various attempts have been made to address these issues, including the incorporation of heat recovery systems into chiller units. These systems aim to capture and reuse waste heat for other heating, cooling, or electrical applications. While these attempts have shown some promise, there is a need for a more efficient and integrated solution that maximizes waste heat recovery while maintaining the chiller unit's primary cooling function.

Therefore, there is a need for a data center chilling system with waste heat recycling that alleviates the aforementioned drawbacks.

### SUMMARY

In one or more embodiments, a system for recycling waste heat air is disclosed. In some embodiments, the system includes: a chiller unit. In some embodiments, the chiller unit includes a cabinet including: at least one side panel; an air inlet; an air outlet; and an air movement unit disposed in the cabinet. In some embodiments, the system includes at least one thermoelectric module coupled to at least one of the at least one side panels of the cabinet, the at least one thermoelectric module including: a first heat transfer surface located on or toward an interior of the cabinet; and a second heat transfer surface located on an exterior of the cabinet wherein the first heat transfer surface is configured to be heated by air moving through the air inlet via the air movement unit thereby creating a temperature gradient between the first heat transfer surface and the second heat transfer surface.

In one or more embodiments, the system is configured for recycling waste heat air from a data center.

In one or more embodiments, the system, further includes at least one external powered device electrically coupled to the thermoelectric module.

In one or more embodiments of the system, the at least one external powered device includes at least one of a lamp, a smoke detector, a fire alarm, or a security alarm.

In one or more embodiments of the system, the at least one external powered device includes a battery.

In one or more embodiments of the system, the battery includes a 6-volt battery or a 12-volt battery.

In one or more embodiments of the system, the at least one external powered device further includes at least one of a lamp, a smoke detector, a fire alarm, or a security alarm.

In one or more embodiments, the system is configured to generate greater than one milliamp-hour of energy storage.

In one or more embodiments of the system, the thermoelectric module includes a width of substantially 40 mm and a length of substantially 40 mm.

In one or more embodiments of the system, a temperature difference between the first heat transfer surface and the second heat transfer surface is greater than 10°C while the chiller unit is operating.

In one or more embodiments of the system, the heat transfer surface is in contact with a surface of the at least one side panel.

In one or more embodiments of the system, the heat transfer surface is in direct contact with the air within the cabinet.

In one or more embodiments, the system includes at least 64 thermoelectric modules.

In one or more embodiments, another system for recycling waste heat air is disclosed. In some embodiments the system includes at least one thermoelectric module couplable to at least one side panel of a cabinet of a chiller unit, the thermoelectric module. In some embodiments, the at least one thermoelectric module includes a first heat transfer surface located on or toward an interior of the cabinet; and a second heat transfer surface located on an exterior of the cabinet wherein the first heat transfer surface is configured to be heated by air moving through an air inlet via an air movement unit thereby creating a temperature gradient between the first heat transfer surface and the second heat transfer surface.

In one or more embodiments, the system is configured for recycling waste heat air from a data center.

In one or more embodiments, the system, further includes at least one external powered device electrically coupled to the thermoelectric module.

In one or more embodiments of the system, the at least one external powered device includes at least one of a lamp, a smoke detector, a fire alarm, or a security alarm.

In one or more embodiments of the system, the at least one external powered device includes a battery.

In one or more embodiments of the system, the heat transfer surface is in contact with a surface of the at least one side panel.

In one or more embodiments of the system, the heat transfer surface is in direct contact with the air within the cabinet.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

**The** detailed description is described with reference to the accompanying figures.
FIG. 1 is a system diagram view of an embodiment of a chilling system with waste heat utilization.
FIG. 2 is an orthogonal view of an alternative embodiment of a chiller unit in a chilling system with waste heat utilization.
FIG 3 is a diagram view of a thermoelectric element in a chilling system with waste heat utilization.

### DETAILED DESCRIPTION

Embodiments of the present disclosure will now be described with reference to the accompanying drawings.

Embodiments are provided so as to thoroughly and fully convey the scope of the present disclosure to the person skilled in the art. Numerous details are set forth, relating to specific components, and methods, to provide a complete understanding of
embodiments of the present disclosure. It will be apparent to the person skilled in the art that the details provided in the embodiments should not be construed to limit the scope of the present disclosure. In some embodiments, well-known processes, well-known apparatus structures, and well-known techniques are not described in detail.

The terminology used in the present disclosure is only for the purpose of explaining a particular embodiment, and such terminology shall not be considered to limit the scope of the present disclosure. As used in the present disclosure, the forms "a," "an," and "the" may be intended to include the plural forms as well, unless the context clearly suggests otherwise. The terms "comprises," "comprising," "including," and "having," are openended transitional phrases and therefore specify the presence of stated features, elements, modules, units and/or components, but do not forbid the presence or addition of one or more other features, elements, components, and/or groups thereof.

Aspects of the disclosure are described more fully hereinafter with reference to the accompanying drawings, which form a part hereof, and which show, by way of illustration, example features. The features can, however, be embodied in many different forms and should not be construed as limited to the combinations set forth herein; rather, these combinations are provided so that this disclosure will be thorough and complete and will fully convey the scope. The following detailed description is, therefore, not to be taken in a limiting sense.

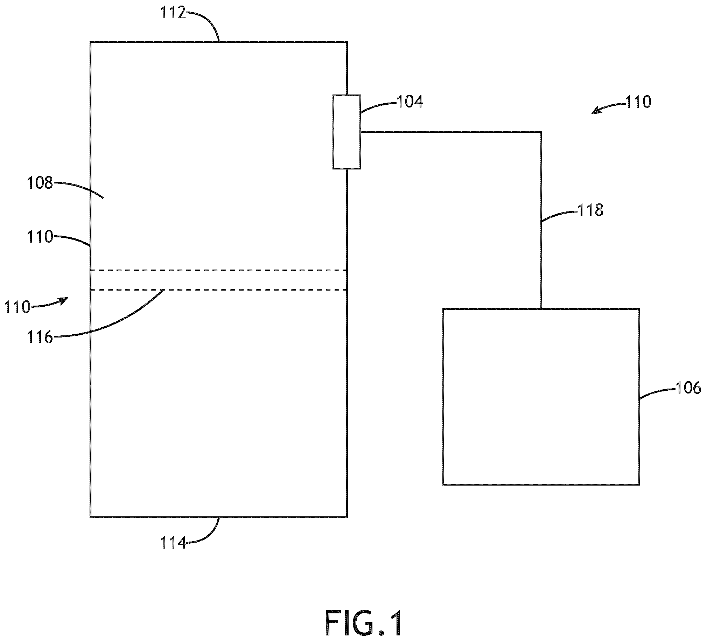

FIG. 1 illustrates a system-level diagram view of an embodiment of a chiller unit with waste heat utilization. The system 100 for recycling waste heat air (e.g., from a data center) may include a chiller unit 102, at least one thermoelectric module 104, and an external powered device 106 (e.g., capable of storing or using power). The chiller unit 102 can include a cabinet 108 with at least one side panel 110. The cabinet 108 can include an air inlet 112 disposed on the top side of the cabinet 108 and an air outlet 114 disposed on the bottom side of the cabinet 108.

In the embodiments, the chiller unit 102 operates by utilizing an air movement unit 116 that can be located in the interior of the cabinet 108. The air movement unit 116 can be a single fan or can be multiple fans. In an embodiment, the air movement unit 116 can contain a single centrifugal fan, which allows air to be moved in a direction perpendicular to the air moving unit, such as outside of the chilling unit. The air movement unit 116 can also be a single axial fan, which moves air in a straight line from the top to the bottom of the cabinet. The air movement unit 116 can also be two or more centrifugal fans, two or more axial fans, or a combination thereof. The air movement unit 116 can also be one or more other fans known in the art. The air movement unit 116 can be permanently fixed within the interior of the cabinet 108 or it can be secured by fasteners in a non-permanent fashion within the interior of the cabinet 108.

In embodiments, the air movement unit 116 pulls air through the air inlet 112 through the cabinet 108. The air that enters the cabinet 108 through the air inlet 112 can be air that was previously used in a data center to cool the environment therein. In an exemplary embodiment, the air pulled through the air inlet 112 by the air movement unit 116 is hot air. As the air moves from the top to the bottom of the cabinet, it is cooled by the chiller unit 102 via an indoor loop.

In this loop, a chilled liquid, usually water or a water-glycol mixture, circulates through a network of pipes and cooling coils located within the indoor environment. The primary function of this chilled liquid is to absorb heat from the indoor air, thus cooling the environment. As the liquid travels through the indoor loop, it passes through various components that facilitate efficient heat exchange. The first of these is the evaporator, where the chilled liquid absorbs heat from the warmer indoor air. This process causes the air temperature to drop, effectively cooling the area. The heat absorbed by the liquid is then carried away as it continues its cycle through the system. An essential aspect of this process is the maintenance of pressure and temperature levels within the system, ensuring that the liquid remains in its chilled state and does not evaporate or change phase. This is achieved through the use of expansion valves and other control mechanisms, which regulate the flow and temperature of the chilled liquid throughout the loop. The air then leaves the cabinet 108 via the bottom air outlet 114, where it can be used to chill the environment and/or heat-generating components inside a data center.

FIG. 1 further illustrates a junction 118 that electrically connects the thermoelectric module 104 with the external powered device 106. When the thermoelectric module 104 generates electrical energy, the junction 118 can allow the electrical energy to be transferred to one or more external powered devices 106. The external powered device 106 can be any electrically powered device in a data center, including but not limited to LED lamps, smoke detection systems, fire alarm systems, a battery, or security systems. The external powered device 106 would otherwise require a direct power source from a utility to be powered. In some instances, the system 100 includes a battery as a first external powered device 106 and second external powered device (e.g., lamps such as light-emitting diode (LED) lamps, smoke detectors or smoke detection systems, fire alarms or fire alarm systems, or security alarms or security systems) that is powered either by the battery or directly via the junction 118. The battery may be of any type and have any storage capacity. For example, the battery may be configured to have a voltage range between 1.0 and 25 volts. For instance, the battery may be configured as a 6-volt battery. In another example, the battery may be configured as a 12-volt battery.

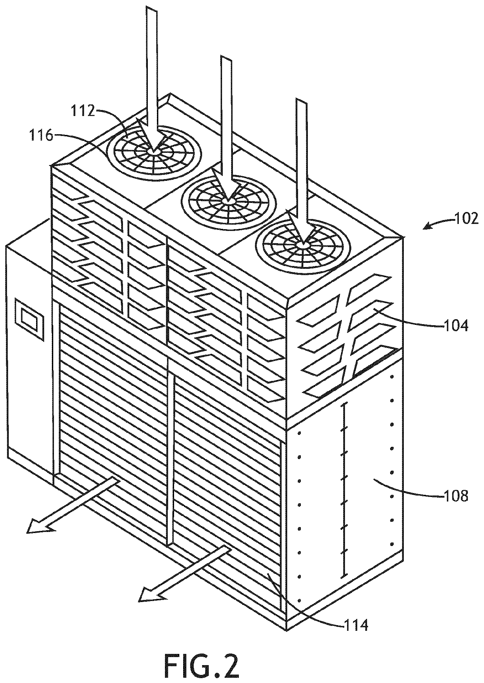

FIG. 2 illustrates an alternative embodiment of the chiller unit 102 in the present disclosure. FIG. 2 includes a chiller unit 102 with a plurality of thermoelectric modules 104. The thermoelectric modules 104 may be evenly displaced on the side walls of the cabinet 108. Also pictured in FIG. 2 is a number of individual air movement units 116. As shown in the alternative embodiment, one or more air movement units 116 can be an axial fan. The thermoelectrical modules 104 allows for additional electrical energy to be created using the hot air moving through the cabinet 108. The thermoelectrical modules 104 can be connected in series to generate a higher voltage. The plurality of thermoelectrical modules 104 can be connected in series or parallel to generate a higher current (e.g., a set of thermoelectrical modules). For example, the system 100 may include two or more thermoelectrical modules 104, four or more thermoelectrical modules 104, eight or more thermoelectrical modules 104, sixteen or more thermoelectrical modules 104, 32 or more thermoelectrical modules 104, or 64 or more thermoelectrical modules 104. For example, the system 100 may include 64 thermoelectrical modules 104, or more than 64 thermoelectrical modules 104, which are all electrically coupled to one or more batteries.

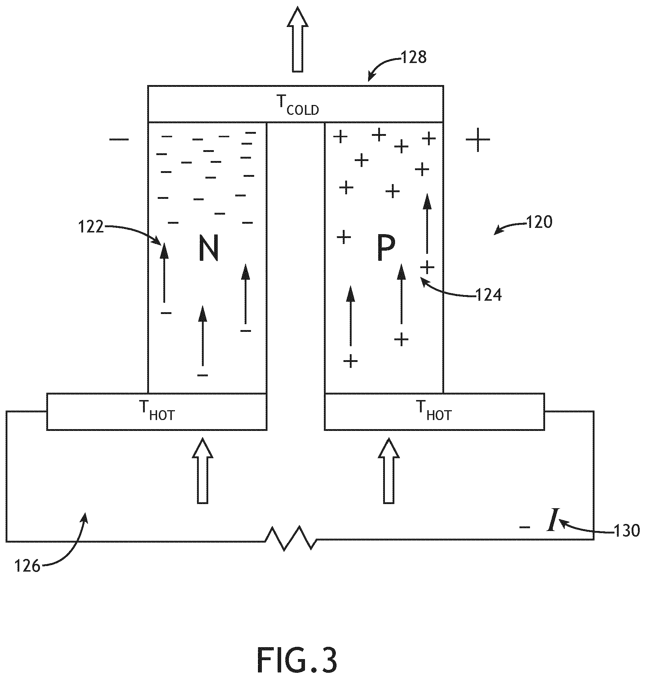

FIG. 3 illustrates a thermoelectric element 120 that, when combined with other thermoelectric elements, makes up a thermoelectric module 104. The thermoelectric element 120 includes an n-type semiconductor 122 and a p-type semiconductor 124. The n-type semiconductor 122 can be doped with an element that has more electrons than necessary to complete its atomic structure, giving it an excess of free electrons, which can serve as charge carriers. By way of example, the n-type semiconductor 122 can be silicon doped with arsenic, silicon doped with phosphorus, arsenic doped with germanium, or germanium doped with phosphorus. The thermoelectric modules 104 may include, but are not limited to, Seebeck modules (e.g., thermoelectric generators) and may include any type of materials including, but not limited to, bismuth telluride (Bi₂Te₃), lead telluride (PbTe), and silicon-germanium (SiGe).

Conversely, the p-type semiconductor 124 can be doped with an element that has fewer electrons than necessary, resulting in positive charge carriers. By way of example, the p-type semiconductor 124 can be boron doped with silicon, aluminum doped with silicon, or boron doped with germanium. Both the n-type semiconductor 122 and the p-type semiconductor 124 are chosen based on their Seebeck coefficient, electrical conductivity, and thermal conductivity, to maximize the power output of the thermoelectric element 120.

In operation, the thermoelectric element 120 is subjected to a temperature gradient with a hot side 126 having a first heat transfer surface and a cold side 128 having a second heat transfer surface. When heat is applied to the hot side 126, a flow of heat forms that goes from the hot side 126 to the cold side 128. During this time, charge carriers from the n-type semiconductor 122 also move from the hot side 126 to the cold side 126. The diffusion of these carriers creates a voltage difference between the hot side 126 and the cold side 128 because of the difference in Seebeck coefficients of the materials. The magnitude of the voltage difference generated is directly proportional to the temperature difference between the hot side 126 and the cold side 128. The charge difference across the thermoelectric element 120 results in an electric current 130 that can be used to power devices near the thermoelectric element 120. The temperature difference maintained between the hot side 126 and the cold side 128, of the thermoelectric elements 120 may be greater than 10°C when incorporated into a system 100 that is actively cooling.

In embodiments, the first heat transfer surface (e.g., the hot side 126) is located on or toward the interior of the cabinet 108, while the second heat transfer surface (e.g., the cold side 128) is located on or toward the exterior of the cabinet 108. For example, the first heat transfer surface may be placed up against the side panel 110 of the cabinet. In another example, the first heat transfer surface may be part of, or integrated with, the side panel 110, with the first heat transfer surface coming into direct contact with the hot air of the interior of the cabinet. In another example, the second heat transfer surface may be positioned on the outer surface of the cabinet 108, as shown in FIG. 2. In another example, fins or other heat-dissipating structures may be positioned on the second heat transfer surface to increase heat loss.

In embodiments, the thermoelectric modules 104 the system 100 are configured to produce multiple milliamps per day for storage into one or more batteries that may be used to power the one or more external powered devices 106. For example, the thermoelectric modules 104 may be configured to generate and store more than .04 milliamp-hour (mAh), more than .08 mAh, more than .2 mAh, more than 0.5 mAh, or more than 1 mAh, more than 2 mAh, more than 4 mAh or more than 8 mAh. For example, the thermoelectric modules 104 may be configured to generate approximately 1 mAh of energy storage, which can be used to power external powered devices 106 such as a smoke detector, a fire alarm, an LED, and/or a security alarm.

**The** individual thermoelectric modules 104 may be formed of any size or shape. For example, the thermoelectric module 104 may include a flat rectangle (e.g., having a hot side and a cold side) that has dimensions of substantially 40 mm (width) by 40 mm (length), with a thickness of approximately 3.5 mm.

In embodiments, the system 100 includes waste heat utilization componentry that can be added to a preexisting chiller unit. For example, the system 100 may include a set of thermoelectric modules 104 that is couplable to a battery or other external powered device 106 that is added on to a preexisting system. The system 100 may further include the junction 118 and/or the at least one external power device (e.g., battery) as described herein.

Also disclosed are the following numbered clauses:
1. A system for recycling waste heat air, the system comprising: at least one thermoelectric module couplable to at least one side panel of a cabinet of a chiller unit, the thermoelectric module comprising: a first heat transfer surface located on or toward an interior of the cabinet; and a second heat transfer surface located on an exterior of the cabinet wherein the first heat transfer surface is configured to be heated by air moving through an air inlet via an air movement unit thereby creating a temperature gradient between the first heat transfer surface and the second heat transfer surface.
**2.** The system of clause 1, wherein the system is configured for recycling waste heat air from a data center.
3. The system of clause 1 or 2, further comprising at least one external powered device electrically coupled to the thermoelectric module.
**4.** The system of clause 3, wherein the at least one external powered device comprises at least one of a lamp, a smoke detector, a fire alarm, or a security alarm.
5. The system of clause 3 or 4, wherein the at least one external powered device comprises a battery.
**6.** The system of any preceding clause, wherein the heat transfer surface is in contact with a surface of the at least one side panel.
**7.** The system of any preceding clause, wherein the heat transfer surface is in direct contact with the air within the cabinet.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and/or firmware.

**The** foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

**Those** having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein-described subject matter sometimes illustrates different components contained within or connected with different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable" to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

The foregoing description of the embodiments has been provided for purposes of illustration and not intended to limit the scope of the present disclosure. Individual components of a particular embodiment are generally not limited to that particular embodiment, but are interchangeable. Such variations are not to be regarded as a departure from the present disclosure, and all such modifications are considered to be within the scope of the present disclosure.

The present disclosure described hereinabove has several technical advantages including, but not limited to, a data center chilling system with waste heat recycling, that; offers improved energy efficiency and reduced greenhouse gas emissions; environmentally friendly and sustainable cooling solutions; maximize waste heat recovery; and scalable and adaptability to specific applications.

The foregoing disclosure has been described with reference to the accompanying embodiments which do not limit the scope and ambit of the disclosure. The description provided is purely by way of example and illustration.

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

The foregoing description of the specific embodiments so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the scope of the embodiments as described herein.

Any discussion of devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

While considerable emphasis has been placed herein on the components and component parts of the preferred embodiments, it will be appreciated that many embodiments can be made and that many changes can be made in the preferred embodiments without departing from the principles of the disclosure. These and other changes in the preferred embodiment as well as other embodiments of the disclosure will be apparent to those skilled in the art from the disclosure herein, whereby it is to be distinctly understood that the foregoing descriptive matter is to be interpreted merely as illustrative of the disclosure and not as a limitation.

## Claims

1. A system for recycling waste heat air, the system comprising:
a chiller unit comprising:
a cabinet comprising:
at least one side panel;
an air inlet;
an air outlet; and
an air movement unit disposed in the cabinet; and
at least one thermoelectric module coupled to at least one of the at least one side panels of the cabinet, the at least one thermoelectric module comprising:
a first heat transfer surface located on or toward an interior of the cabinet; and
a second heat transfer surface located on an exterior of the cabinet wherein the first heat transfer surface is configured to be heated by air moving through the air inlet via the air movement unit thereby creating a temperature gradient between the first heat transfer surface and the second heat transfer surface.

2. The system of claim 1, wherein the system is configured for recycling waste heat air from a data center.

3. The system of claim 1 or 2, further comprising at least one external powered device electrically coupled to the thermoelectric module.

4. The system of claim 3, wherein the at least one external powered device comprises at least one of a lamp, a smoke detector, a fire alarm, or a security alarm.

5. The system of claim 3, wherein the at least one external powered device comprises a battery.

6. The system of claim 5, wherein the battery comprises a 6-volt battery or a 12-volt battery.

7. The system of claim 5 or 6, wherein the at least one external powered device further comprises at least one of a lamp, a smoke detector, a fire alarm, or a security alarm.

8. The system of any preceding claim, wherein the system is configured to generate greater than one milliamp-hour of energy storage.

9. The system of any preceding claim, wherein the thermoelectric module comprises a width of substantially 40 mm and a length of substantially 40 mm.

10. The system of any preceding claim, wherein a temperature difference between the first heat transfer surface and the second heat transfer surface is greater than 10°C while the chiller unit is operating.

11. The system of any preceding claim, wherein the heat transfer surface is in contact with a surface of the at least one side panel.

12. The system of any preceding claim, wherein the heat transfer surface is in direct contact with the air within the cabinet.

13. The system of any preceding claim, wherein the system comprises at least 64 thermoelectric modules.
